# EUROPÄISCHE PATENTSCHRIFT

(11) **EP 4 602 376 B1**
(45) Veröffentlichungstag und Bekanntmachung des Hinweises auf die Patenterteilung: **02.12.2026**
(21) Anmeldenummer: 23786563.9
(22) Anmeldetag: 10.10.2023
(51) Int. Cl.: G01P 21/00, G01P 15/097, G01P 15/125, G01R 5/00, G01R 19/00, G01R 15/00, G01P 15/08, G01R 15/14

(54) **VERFAHREN UND VORRICHTUNG ZUM MESSEN EINER SPANNUNG**
METHOD AND DEVICE FOR MEASURING A VOLTAGE
PROCÉDÉ ET DISPOSITIF DE MESURE DE TENSION

(30) Priorität: 14.10.2022 DE 102022126948
(43) Veröffentlichungstag der Anmeldung: 20.08.2025
(73) Patentinhaber: Northrop Grumman LITEF GmbH, 79115 Freiburg (DE)
(72) Erfinder: KÖNIG, Stefan, 79219 Staufen (DE)
(74) Vertreter: Müller Hoffmann & Partner
(86) Internationale Anmeldenummer: PCT/EP2023/077992
(87) Internationale Veröffentlichungsnummer: WO 2024/079092

(56) Entgegenhaltungen:
- US-A1- 2017 191 830
- US-A1- 2018 100 880
- US-B1- 11 307 217

## Beschreibung

Die vorliegende Erfindung betrifft ein Verfahren zum Messen einer Spannung mittels eines mikro-elektro-mechanischen Systems und ein derartiges mikro-elektro-mechanisches System.

In einer Vielzahl von Anwendungen der Elektronik kommen Referenzspannungsquellen zum Einsatz, die eine Spannung vorgeben, auf deren Grundlage weitere Operationen ausgeführt werden. Zum Beispiel werden in Analog-Digital-Wandlern Referenzspannungen zum Abtasten des analogen Signals verwendet. Auch werden basierend auf Referenzspannungen andere, in dem entsprechenden Elektronikbauteil verwendete Parameter festgelegt bzw. berechnet, wie etwa Spannungswerte oder Stromgrößen.

Insbesondere bei Beschleunigungs- oder Drehratensensoren, die als mikro-elektro-mechanische Systeme, MEMS, ausgebildet sind, werden Referenzspannungen gebraucht, um die verwendeten Antriebs- und/oder Auslesespannungen auf vorgegebene bzw. vorgebbare Werte zu setzen. So skaliert z.B. die Messgenauigkeit von Beschleunigungssensoren typischer Weise quadratisch mit der Spannung, die zwischen einer Schwingungsmasse des Sensors und seinen Antriebs-/Ausleseelektroden angelegt wird. Der sogenannte Skalenfaktor, der die durch die Auslenkung der Probemasse verursachte und messbare Kapazitäts- bzw. Ladungsänderung in die eigentlich interessierende Beschleunigung umsetzt, ist damit quadratisch von dieser Antriebs-Auslesespannung abhängig. Da diese wiederum basierend auf einer Referenzspannung erzeugt oder festgesetzt wird, hängt der Skalenfaktor quadratisch von der Größe der Referenzspannung ab.

Hochleistungsbauteile, wie etwa hochgenaue Beschleunigungs- oder Drehratensensoren, unterliegen dabei der Anforderung, dass sie langzeitstabil sind, d.h. dass ihre Rechen- oder Messergebnisse über sehr lange Zeit, z.B. über 10 Jahre oder mehr, von gleicher Qualität sind und insbesondere keine zeitliche Drift, d.h. kein kontinuierliches Anwachsen oder Absinken erfolgt.

Für den Skalenfaktor von Beschleunigungssensoren ist hier z.B. bei gleichbleibenden Betriebs- und Umgebungsbedingungen während des Produktlebenszyklus des Beschleunigungssensors eine Abweichung von weniger als 100ppm pro Jahr akzeptabel, d.h. eine Abweichung die nur 100 Millionstel des Skalenfaktors zu Beginn des Produktlebenszyklus beträgt.

Typische Referenzspannungsquellen erreichen aber nur eine Genauigkeit z.B. in der Größenordnung von 50ppm pro Jahr. Dies ergibt aufgrund der quadratischen Anhängigkeit des Skalenfaktors von der Referenzspannung bereits eine Veränderung des Skalenfaktors von 100ppm pro Jahr. Bezieht man noch die Alterungserscheinungen weiterer Komponenten mit ein, ergibt sich für einen typischerweise realisierbaren Beschleunigungssensor eine Drift des Skalenfaktors, und damit der Messwerte, von mindestens 300ppm pro Jahr. Diese beeinflusst über den Offset/Bias des Sensors auch die Genauigkeit der Messung bis hin zu Werten von 50 bis 100 µg, was ohne Korrektur zu viel für einen hochgenauen Beschleunigungssensor ist.

In ähnlicher Weise lassen sich auch die über die Zeit auftretenden Ungenauigkeiten von anderen elektronischen Bauelementen abschätzen. Auch hier ist häufig die zeitliche Drift von Referenzspannungen hauptverantwortlich für die Drift des Gesamtbauteils.

Eine Verbesserung der Genauigkeit von Referenzspannungsquellen ist hierbei nicht oder nur in komplizierter Weise möglich. Zudem ergibt sich das Problem, dass die direkte Messung der Referenzspannungen mit einer ähnlichen zeitlichen Drift bzw. einer intrinsischen Messungenauigkeit behaftet ist, die ähnlich groß ist, wie die Drift der Referenzspannung.

Das Dokument US 11 307 217 B1 ist Bestandteil des Stands der Technik. Es offenbart das Messen einer Spannung, die an Trimmelektroden eines resonanten MEMS angelegt wird, durch Messen der Verschiebung der Resonanzfrequenz der Testmasse.

Aufgabe der vorliegenden Erfindung ist also, ein Verfahren zum Messen Referenzspannung anzugeben, das ausreichend genau ist, um die Langzeitdrift der Spannung zu detektieren. Aufgabe der vorliegenden Erfindung ist ebenso, eine Vorrichtung anzugeben, die ein derartiges Verfahren umsetzen kann.

Diese Aufgabe wird durch den Gegenstand der unabhängigen Ansprüche gelöst. Vorteilhafte Weiterbildungen sind in den abhängigen Ansprüchen definiert.

Insbesondere verwendet ein Verfahren zum Messen einer Spannung ein mikro-elektro-mechanischen System, MEMS. Das MEMS weist hierbei eine Probemasse, die mittels mechanischen Federelementen derart über einem Substrat gelagert wird, dass sie entlang einer Schwingungsrichtung relativ zu dem Substrat bewegt werden kann, Trimmelektroden, die geeignet sind, bei einer Beaufschlagung mit einer Spannung eine elektrostatische Kraft auf die Probemasse zu erzeugen, die bei einer Auslenkung der Probemasse entlang der Schwingungsrichtung einer durch die Federelemente erzeugten mechanischen Federkraft entgegenwirkt, Antriebselektroden, die geeignet sind, die Probemasse entlang der Schwingungsrichtung in Bewegung zu versetzen, und Ausleseelektroden auf, die geeignet sind, eine Schwingungsfrequenz der derart erzeugten Schwingung der Probemasse zu messen. Das Verfahren umfasst dabei: Anlegen einer zu messenden Spannung an die Trimmelektroden; Messen der Größe der zu messenden Spannung aus der gemessenen Schwingungsfrequenz der Probemasse; und Detektieren von Änderungen der zu messenden Spannung anhand der Änderung der gemessenen Schwingungsfrequenz.

Die Detektion der zu messenden Spannung wird also über die Bestimmung der Schwingungsfrequenz eines Schwingungssystems gelöst. Da sich Schwingungsfrequenzen wesentlich genauer bestimmen lassen als Spannungen, wird bereits hierdurch ein entscheidender Beitrag zur oben gestellten Aufgabe geleistet. Zudem wird durch das Anlegen der zu messenden Spannung an die Trimmelektroden erreicht, dass die Spannung das Schwingungsverhalten der Probemasse wesentlich beeinflusst. Durch die an den Trimmelektroden anliegende Spannung wird effektiv die Federkonstante des Schwingungssystems verändert. Dies erlaubt es, durch ein entsprechendes Design des MEMS, d.h. unter anderem der mechanischen Federkonstante, eine effektive Federkonstante einzustellen, die besonders günstig für die Detektion von Frequenzänderungen aufgrund von Änderungen der zu messenden Spannung ist. Durch das Anlegen der zu messenden Spannung an die Trimmelektroden ist es also möglich, die Messgenauigkeit weiter zu steigern.

Die zu messende Spannung ist eine Referenzspannung, deren Größe die Grundlage weiterer Mess- und/oder Rechenoperationen ist. Dann weist das Verfahren des Weiteren auf: Korrigieren der weiteren Mess- und/oder Rechenoperationen durch Ersetzen der erwarteten Referenzspannung durch die gemessene Referenzspannung. Weitere Operationen, wie z.B. Analog-Digital-Wandlungen, Bestimmungen von Messwerten mittels eines Skalenfaktors oder dergleichen werden also nicht mit der bei Fertigung der Referenzspannungsquelle angegebenen Referenzspannung durchgeführt, sondern mit dem gemessenen Spannungswert. Ebenso werden die Werte von aus der Referenzspannung (z.B. analog) abgeleiteten Größen basierend auf dem Messwert der Referenzspannung aktualisiert bzw. korrigiert. Dadurch verbessert sich das Ergebnis der weiteren Mess- und/oder Rechenoperationen.

Durch das Anlegen der zu messenden Spannung an die Trimmelektroden können zwischen 50% und 90%, vorzugsweise zwischen 60% und 80%, weiter vorzugsweise 75% der mechanischen Federkraft kompensiert werden. Diese Kompensationswerte sind besonders vorteilhaft für die Größe der Frequenzänderung nach Änderungen der zu messenden Spannung. Damit steigt die Genauigkeit der Messung. Die Größe der Kompensation kann durch ein entsprechendes Design des MEMS erreicht werden, d.h. insbesondere der Trimmelektroden und/oder der Federelemente und der durch diese vorgegebenen Federkonstanten, sobald die Größe der zu messenden Spannung bekannt ist. So lassen sich besonders empfindliche MEMSs herstellen, die auf bestimmte Spannungsgrößen eingestellt sind.

Das Verfahren kann insbesondere dann ausgeführt werden, wenn das MEMS sich in Ruhe befindet, d.h. wenn keine starken Vibrationen oder Linearbeschleunigungen anliegen. Dadurch werden Störungen durch übermäßige Bewegungen vermieden. Zum Beispiel kann das Verfahren immer dann ausgeführt werden, wenn die elektronische Komponente, deren Referenzspannung gemessen werden soll, gestartet wird. Insbesondere wenn es sich hierbei um einen Beschleunigungssensor handelt, ist dann zu erwarten, dass sich das MEMS in Ruhe oder nahezu in Ruhe befindet. Hierdurch können verlässliche Werte für die zu messende Spannung gewonnen werden.

Ein mikro-elektro-mechanisches System, MEMS, zum Messen einer Spannung weist eine Probemasse, die mittels mechanischen Federelementen derart über einem Substrat gelagert wird, dass sie entlang einer Schwingungsrichtung relativ zu dem Substrat bewegt werden kann, Trimmelektroden, die geeignet sind, bei einer Beaufschlagung mit einer Spannung eine elektrostatische Kraft auf die Probemasse zu erzeugen, die bei einer Auslenkung der Probemasse entlang der Schwingungsrichtung einer durch die Federelemente erzeugten mechanischen Federkraft entgegenwirkt, Antriebselektroden, die geeignet sind, die Probemasse entlang der Schwingungsrichtung in Bewegung zu versetzen, und Ausleseelektroden auf, die geeignet sind, eine Schwingungsfrequenz der derart erzeugten Schwingung der Probemasse zu messen. Das MEMS weist des Weiteren eine Steuereinheit auf, die geeignet ist, das MEMS derart zu steuern, dass es die oben beschriebenen Verfahren ausführt.

Mit einem derartigen MEMS lassen sich die oben genannten positiven Effekte erzielen.

Das MEMS kann derart ausgestaltet sein, dass sich die Resonanzfrequenz der Schwingung der Probemasse bei mit der zu messenden Spannung beaufschlagten Trimmelektroden bei einer Spannungsänderung von 1 mV um einen Wert aus dem Bereich 100 ppm bis 1.000 ppm der Resonanzfrequenz ändert. Das MEMS ist also derart ausgelegt, dass relativ kleine Änderungen der an den Trimmelektroden angelegten Spannung im Millivoltbereich, d.h. z.B. von ca. 100ppm bei einer Spannung von 10V, zu Änderungen der Resonanzfrequenz führen, die wesentlich größer sind als Stabilitätsschwankungen der Resonanzfrequenz von weniger als10ppm. Dies führt dann zu einer hohen Genauigkeit bei der Messung von Änderungen der Resonanzfrequenz, die zu einer hohen Genauigkeit bei der Messung von Änderungen der an den Trimmelektroden anliegenden Spannung führt.

Hierbei kann die Änderung der Resonanzfrequenz mit der Spannungsänderung nicht linear von der Auslenkung der Probemasse abhängen und/oder die Resonanzfrequenz kann sich mit der Umgebungstemperatur ändern. Die Steuereinheit ist dann geeignet, diese Abhängigkeiten durch Kalibration beim Detektieren der zu messenden Spannung zu berücksichtigen. Sowohl die Größer der Schwingungsamplitude der Probemasse als auch Änderungen der Temperatur der Bauteile des MEMS, z.B. aufgrund von Schwankungen der Umgebungstemperatur können die mechanische Federkonstante und die durch die Trimmelektroden erzeugte elektrostatische Federkonstante beeinflussen. Dadurch ergeben sich für unterschiedliche Auslenkungen der Probemasse und/oder Temperaturen innerhalb des MEMS unterschiedlich starke Änderungen der Resonanzfrequenz aufgrund einer sich ändernden Spannung an den Trimmelektroden. Diese Relation ist hierbei meist nicht linear.

Die Steuereinheit kann deshalb geeignet sein, eine Kalibration des Systems durchzuführen, z.B. durch bekannte Änderungen der Spannung an den Trimmelektroden bei verschiedenen Schwingungsamplituden oder Temperaturen und Bestimmung der daraus resultierenden Änderungen der Resonanzfrequenz. Die dadurch gewonnenen Relationen können direkt genutzt werden, um Messwerte im Betrieb auf bestimmte Normwerte der Schwingungsamplitude und/oder der Temperatur zu korrigieren. Umgekehrt ist es auch möglich, durch Verwendung von bekannten Spannungsänderungen aus den Messwerten für die Veränderung der Resonanzfrequenz die Temperatur und/oder die Schwingungsamplitude zu bestimmen. Eine Kalibration ist z.B. nicht notwendig, wenn die Schwingungsamplitude konstant gehalten wird und/oder die Messungen nur in einem vorgegebenen Temperaturbereich vorgenommen werden.

Das MEMS kann derart ausgestaltet sein, dass das durch die Schwingungen der Probemasse erzeugte Schwingungssystem bei mit der zu messenden Spannung beaufschlagten Trimmelektroden eine Güte von mehr als 1.000 aufweist. Dadurch werden Veränderungen der Resonanzfrequenz besonders gut messbar.

Die Probemasse, die Federelemente, die Trimmelektroden, die Antriebselektroden und die Ausleseelektroden können hierbei evakuiert sein, z.B. durch Einschluss in ein gemeinsames, evakuiertes Gehäuse. Dies führt durch den Wegfall des Luftwiderstandes zu einer Erhöhung der Güte des Systems, wodurch sich wiederum die Messgenauigkeit erhöht.

Ein Beschleunigungssensor zum Messen von Beschleunigungen kann ein MEMS aufweisen, wie es oben beschrieben wurde. Hierbei ist das MEMS geeignet, eine Beschleunigung zu messen, die entlang der Schwingungsrichtung der Probemasse auf den Beschleunigungssensor wirkt, indem die Schwingungsfrequenz der Probemasse gemessen wird. Das Schwingungssystem des MEMS wird also nicht nur zur Detektion von Änderungen der an den Trimmelektroden anliegenden Spannung verwendet, sondern hauptsächlich, um Änderungen der Schwingung aufgrund von an der Probemasse anliegenden Beschleunigungen zu messen. Die beiden Signale können hierbei aufgrund der unterschiedlichen Zeitkonstanten leicht unterschieden werden. Änderungen der zu messenden Spannung haben eine sehr lange Zeitkonstante, z.B. von Monaten oder Jahren, während Beschleunigungen naturgemäß kurzfristig wirken, d.h. im Bereich von Sekunden, Minuten oder Stunden.

Hierbei ist die zu messende Spannung gleich einer Referenzspannung zur Bestimmung einer an die Antriebselektroden und/oder Ausleseelektroden angelegten Betriebsspannung. Das heißt, die zu messende Spannung ist die Spannung, die den Skalenfaktor der Beschleunigungsmessung bestimmt. Dadurch ist es möglich, Änderungen des Skalenfaktors aufgrund einer Drift der Referenzspannung zu erkennen und zu korrigieren. Besonders vorteilhaft ist hierbei, dass dies mit den für die Beschleunigungsmessung vorhandenen Komponenten ausgeführt werden kann, wodurch das Vorhalten von weiteren Bauteilen oder Strukturen verhindert werden kann. Auf diese Weise können hochgenaue, kompakte und langzeitstabile Beschleunigungssensoren bereitgestellt werden.

Die Erfindung wird im Folgenden mit Bezug auf die Figuren weiter beschrieben. Diese Beschreibung ist als rein beispielhaft zu verstehen. Die Erfindung ist allein durch die Ansprüche definiert. Es zeigt:
- Fig. 1: eine schematische Darstellung eines mikro-elektro-mechanischen Systems, MEMS, zum Messen einer Spannung;
- Fig. 2: ein schematisches Ablaufdiagram eines Verfahrens zum Messen einer Spannung mittels eines MEMS;
- Fig. 3: eine schematische Darstellung eines MEMS zum Messen einer Referenzspannung;
- Fig. 4: eine schematische Darstellung eines weiteren MEMS zum Messen einer Spannung;
- Fig. 5: eine schematische Darstellung eines Beschleunigungssensors mit einem MEMS zum Messen einer Antriebs- und/oder Auslesespannung;
- Fig. 6: eine schematische Darstellung eines weiteren MEMS zum Messen einer Spannung; und
- Fig. 7: eine schematische Darstellung eines weiteren MEMS zum Messen einer Spannung.

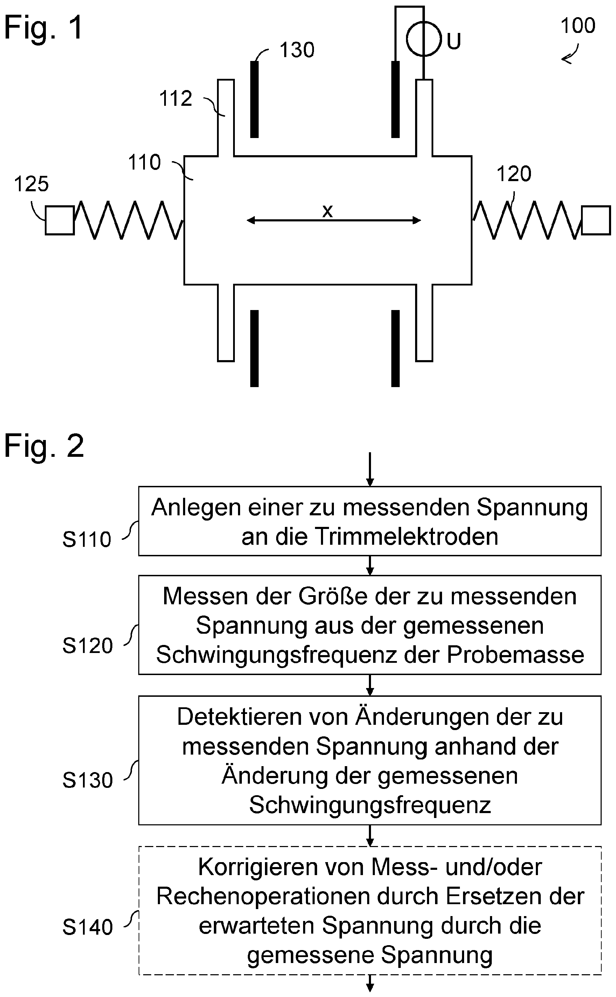

Die Fig. 1 zeigt eine schematische Darstellung eines mikro-elektro-mechanisches Systems MEMS, 100 zum Messen einer Spannung U. Das MEMS 100 weist hierbei eine Probemasse 110, mechanische Federelemente 120 und Trimmelektroden 130 auf.

Die Probemasse 110 ist mittels der mechanischen Federelemente 120 derart über einem Substrat gelagert, dass sie entlang einer Schwingungsrichtung x relativ zu dem Substrat bewegt werden kann. In der Fig. 1 liegt das Substrat parallel zur Zeichnungsebene z.B. unter der gezeigten Probemasse 110. Die Probemasse 110 kann hierbei im Prinzip jede beliebige Form annehmen, solange sich die im Folgenden beschriebenen Effekte hiermit realisieren lassen. Typischer Weise wird die Probemasse 110 eine zum Substrat flächige Ausdehnung haben, d.h. Abmessungen parallel zum Substrat sind weit größer als die Ausdehnung senkrecht zum Substrat.

Die Federelemente 120 sind hierbei in der Fig. 1 rein symbolisch dargestellt und können im Prinzip jegliche beliebige Form annehmen, die es erlaubt, die Probemasse 110 linear entlang einer bestimmten Schwingungsrichtung x zu führen. Es können hierbei auch Schwingungen in mehrere verschiedene Schwingungsrichtungen möglich sein. Vorzugsweise erlauben die Federelemente 120 aber nur eine Schwingung der Probemasse 110 entlang der Schwingungsrichtung x, d.h. die Probemasse 110 ist in der Schwingungsrichtung x bis auf rückstellende Federkräfte frei bewegbar, während Bewegungen senkrecht zur Schwingungsrichtung x im Vergleich hierzu stark unterdrückt und daher vernachlässigbar klein sind. Die Federelemente 120 sind über Anker 125 mit dem Substrat verbunden.

Die Trimmelektroden 130 können relativ zur Probemasse 110 mit einer Spannung U beaufschlagt werden, z.B. durch Zuführen von Ladungen auf die Trimmelektroden 130 und/oder die Probemasse 110. Die Größe der Spannung U kann hierbei bekannt sein.

Wie in der Fig. 1 gezeigt, kann die Probemasse 110 Gegenelektroden 112 aufweisen. Die Spannung U kann dann nur zwischen einer Trimmelektrode 130 und der entsprechenden Gegenelektroden 112 anliegen. Die Gegenelektroden 112 können hierbei aus demselben Material wie der Rest der Probemasse 110 bestehen und leitfähig damit verbunden sein. Die Gegenelektroden 112 können aber auch elektrisch isoliert vom Rest der Probemasse 110 sein.

Durch die Spannung U entsteht eine elektrostatische Kraft auf die Probemasse 110. Die Trimmelektroden 130 sind hierbei derart ausgestaltet bzw. derart relativ zu der Probemasse 110 angeordnet, dass die elektrostatische Kraft bei einer Auslenkung der Probemasse 110 entlang der Schwingungsrichtung x einer durch die Federelemente 120 erzeugten mechanischen Federkraft entgegenwirkt. Wenn also bei einer Auslenkung z.B. nach rechts, die Federelemente 120 die Probemasse wieder zurück in die Ausgangslage, d.h. nach links, bewegen, entsteht zwischen den Trimmelektroden 130 und der Probemasse 110 eine Kraft in Auslenkungsrichtung, d.h. nach rechts. Durch Verändern der Spannung U an den Trimmelektroden 130 kann also die effektive Federkonstante des gesamten Schwingungssystems verändert werden, je nachdem welcher Teil der mechanischen Federkraft durch die elektrostatische Federkraft kompensiert wird. Ebenso kann für den Fall, dass die Spannung U auf einen bestimmten Bereich festgelegt ist, durch die Ausgestaltung des MEMS 100, d.h. insbesondere der Probemasse 110, der Federelemente 120 und/oder der Trimmelektroden 130 ein bestimmtes Kompensationsverhältnis erreicht werden. Die effektive Federkonstante bzw. Differenz aus mechanischer Federkraft und elektrostatischer Kraft bestimmt dann naturgemäß die Resonanzfrequenz der Schwingung der Probemasse 110 entlang der Schwingungsrichtung x.

Das MEMS 100 kann hierbei Antriebselektroden aufweisen, die geeignet sind, die Probemasse 110 entlang der Schwingungsrichtung x in Bewegung zu versetzen. Das MEMS 100 kann auch Ausleseelektroden aufweisen, die geeignet sind, eine Schwingungsfrequenz der derart erzeugten Schwingung der Probemasse 110 zu messen. Die Probemasse 110 kann aber auch anderweitig in Schwingung versetzt werden, z.B. durch Bewegungen des MEMS 100 oder durch eine Kopplung an andere Schwingungssysteme. Antriebselektroden sind also nicht zwingend notwendig und daher in der Fig. 1 nicht gezeigt.

Auch kann auf spezielle Ausleseelektroden verzichtet werden, da eine Detektion der Schwingungsfrequenz auch über die Trimmelektroden 130 möglich ist. Zum Beispiel kann bei konstanter Spannung U über eine Ladungsmessung die Kapazitätsveränderung des durch Trimmelektrode 130 und Gegenelektrode 112 gebildeten Kondensators festgestellt werden. Dies erlaubt eine Abstandsbestimmung, deren zeitlicher Verlauf die Bestimmung der Schwingungsfrequenz erlaubt. Es sind aber auch andere Ausleseschemata denkbar. In diesem Fall fungiert zumindest eine Trimmelektrode 130 als Ausleseelektrode.

Das MEMS 100 weist des Weiteren eine Steuereinheit (nicht gezeigt) auf, die geeignet ist, das MEMS 100 derart zu steuern, dass es ein Verfahren zur Messung der zwischen Trimmelektroden 130 und Probemasse 110 anliegenden Spannung U ausführt. Die Steuereinheit kann hierbei auf dem Substrat des MEMS 100 ausgebildet sein. Die Steuereinheit kann aber auch extern angeordnet sein. Das von dem MEMS 100 ausgeführte Verfahren kann mit Bezug auf die Fig. 2 wie folgt schematisch zusammengefasst werden.

Bei S110 wird die zu messenden Spannung U an die Trimmelektroden 130 angelegt und dadurch die elektrostatische Kraft auf die Probemasse 110 erzeugt, die die mechanische Federkraft teilweise kompensiert.

Bei S120 wird die Größe der zu messenden Spannung U aus der gemessenen Schwingungsfrequenz der Probemasse 110 bestimmt. Da die mechanischen Eigenschaften des MEMS 100 im Prinzip durch die Fertigung vorgegeben und damit bekannt sind, lässt sich der Einfluss der Spannung U auf die effektive Federkonstante und damit auf die Schwingungsfrequenz der Probemasse 110 bestimmen. Zudem ist es möglich, die Schwingungsfrequenz bei ansonsten gleichbleibenden Betriebsparametern ohne und mit der an die Trimmelektroden 130 angelegten Spannung U zu messen. Durch einen Vergleich der Messergebnisse lässt sich ebenfalls auf die Größe der Spannung U schließen.

Bei S130 werden Änderungen der zu messenden Spannung U anhand der Änderung der gemessenen Schwingungsfrequenz bestimmt. Insbesondere können kleine Änderungen der Spannung U im Millivoltbereich, die über einen langen Zeitraum, z.B. über 1 Jahr oder 10 Jahre, erfolgen, über Änderungen der Schwingungsfrequenz mit größerer Genauigkeit als bei einer direkten Spannungsmessung bestimmt werden, da Änderungen der Schwingungsfrequenz sich mit großer Genauigkeit bestimmen lassen.

Auf diese Weise lassen sich kleine Veränderungen einer an sich als konstant angenommenen Spannung über lange Zeiträume präzise bestimmen. Bevorzugter Weise werden durch das Anlegen der Spannung U an die Trimmelektroden 130 zwischen 50% und 90%, vorzugsweise zwischen 60% und 80%, weiter vorzugsweise 75% der mechanischen Federkraft kompensiert. Wie weiter unten erläutert wird, ist das MEMS 100 bei einer derartigen Parameterwahl bzw. bei einem derartigen Layout des MEMS 100 ausreichend sensitiv für Änderungen der zu messenden Spannung U.

Das Verfahren wird hierbei bevorzugt ausgeführt, während das MEMS 100 sich in Ruhe befindet, bzw. wenn erwartet werden kann, dass eine Ruheposition vorliegt, wie etwa beim Betriebsstart des MEMS 100 oder des Gerätes in dem die zu messende Spannung U verwendet wird. Das Verfahren beruht im Prinzip auf der Detektion der Veränderung der effektiven Federkonstante, die sich in einer Veränderung der ausgeführten Schwingung niederschlägt. Da Bewegungen und insbesondere Beschleunigungen des MEMS 100 diese Schwingung stören können, ist ein Betrieb in Ruhe für verlässliche Ergebnisse vorzuziehen. Ansonsten ist es notwendig, die Störungen zu detektieren und zu kompensieren.

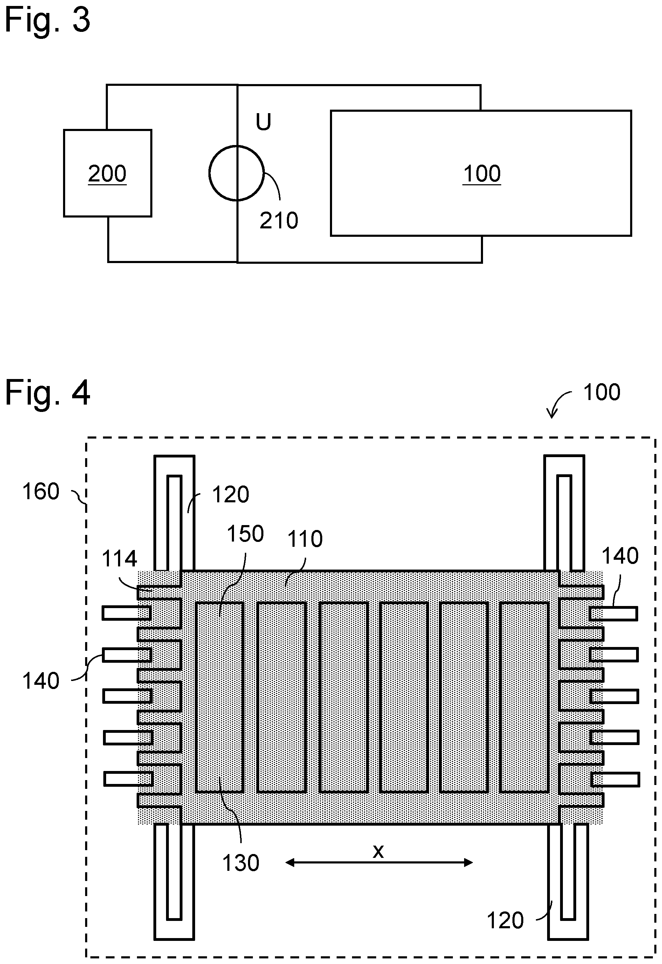

Wie schematisch in der Fig. 3 dargestellt ist, ist die zu messende Spannung U eine Referenzspannung, deren Größe die Grundlage weiterer Mess- und/oder Rechenoperationen ist. Die Referenzspannung U wird dabei für den Betrieb einer elektronischen Komponente 200 benötigt, etwa eines Spannungswandlers, eines Analog-Digital-Wandlers, eines Sensors, z.B. eines Beschleunigungssensors, und wird hierbei von einer Referenzspannungsquelle 210 erzeugt. Die elektronische Komponente 200 führt basierend auf der Referenzspannung U Mess- und/oder Rechenoperationen durch. Zum Beispiel kann die Referenzspannung U als Referenz oder Vergleichswert für verschiedene in der elektronischen Komponente 200 verwendete Spannungs- und oder Stromgrößen dienen. Wie oben erläutert können auch Messergebnisse von als Sensoren ausgestalteten elektronischen Komponenten 200 von der Größe der Referenzspannung abhängen. Das ebenfalls mit der Referenzspannung U versorgte MEMS 100 kann hierbei Teil der elektronischen Komponente 200 sein oder als separates Bauteil vorliegen.

Wie in der Fig. 2 durch die gestrichelte Linie symbolisiert, beinhaltet das Verfahren dann bei S140 des Weiteren, dass die weiteren Mess- und/oder Rechenoperationen durch Ersetzen der erwarteten Referenzspannung durch die gemessene Referenzspannung U korrigiert werden. Dies erlaubt dann einen langzeitstabilen Betrieb der auf der Referenzspannung basierenden Funktionen der elektronischen Komponente 200.

Besonders bevorzugt sind Ausgestaltungen des MEMS bei denen sich die Resonanzfrequenz der Schwingung der Probemasse 110 bei mit der zu messenden Spannung U beaufschlagten Trimmelektroden 130 bei einer Spannungsänderung von 1 mV um einen Wert aus dem Bereich 100 ppm bis 1.000 ppm der Resonanzfrequenz ändert. Dadurch wird eine besonders genaue und verlässliche Messung der Spannung U ermöglicht.

Eine schematische Darstellung eines Designs eines MEMS 100, mit der die obenstehenden Anforderungen beispielsweise erfüllt werden können, ist in der Fig. 4 gezeigt. Sämtliche Bauteile sind hierbei z.B. aus Silizium gefertigt.

Wie in der Fig. 4 gezeigt, kann die Probemasse 110 als rechteckige, durchbrochene Struktur ausgebildet sein, in der die Trimmelektroden 130 angeordnet sind. Die Trimmelektroden 130 bilden also auf platzsparendende Weise Plattenkondensatoren mit Seitenflächen der Aussparungen in der Probemasse 110.

Die Probemasse 110 ist in symmetrischer Weise an ihren vier Ecken über als gefaltete Biegebalkenfedern ausgestaltete Federelemente 120 über dem Substrat gelagert. Die Biegebalkenfedern erstrecken sich hierbei senkrecht zur Schwingungsrichtung x und erlauben daher, dass die Probemasse 110 in diese Richtung schwingen kann, während Bewegungen in die anderen Richtungen bis zu vernachlässigbarer Stärke unterdrückt sind.

Der Antrieb der Schwingung der Probemasse 110 erfolgt über in Schwingungsrichtung x seitlich angeordnete Antriebselektroden 140, die in Gegenelektroden 114 der Probemasse 110 eingreifen. Die Schwingungsparameter werden über die Trimmelektroden 130 ausgelesen, die daher auch als Ausleseelektroden 150 dienen. Es können aber auch die Antriebselektroden 140 als Ausleseelektroden 150 fungieren oder separate Ausleseelektroden 150 vorgesehen sein.

Die zwischen Trimmelektroden 130 und Probemasse 110 wirkende Kraft führt zu einer elektrostatischen Federkonstante für die Schwingung der Probemasse, die wie folgt definiert ist: ${k}_{el} \left(U\right) = - \frac{2 ⋅ N ⋅ {ε}_{0} ⋅ h ⋅ L ⋅ {U}^{2}}{{d}^{3}} = - g ⋅ {U}^{2}$

Hierbei ist N die Anzahl der Trimmelektroden, h deren Höhe senkrecht zum Substrat, L deren Länge parallel zum Substrat und senkrecht zur Schwingungsrichtung x und d der Spaltabstand zwischen Trimmelektroden 130 und Probemasse 110 in Ruhe.

Daraus resultiert die durch die effektive Federkonstante k_{eff} bestimmte Resonanzfrequenz $\begin{matrix}f \left(U\right) = \frac{1}{2 π} ⋅ \sqrt{\frac{{k}_{eff} \left(U\right)}{m}} = \frac{1}{2 π} ⋅ \sqrt{\frac{{k}_{m} + {k}_{el} \left(U\right)}{m}} = \frac{1}{2 π} ⋅ \sqrt{\frac{{k}_{m} - g ⋅ {U}_{in}^{2}}{m}} = \\ = \frac{1}{2 π \sqrt{m}} ⋅ \sqrt{{k}_{m} - g ⋅ {U}_{in}^{2}}\end{matrix}$ wobei m die Masse der Probemasse 110 bezeichnet und die mechanische Federkonstante kₘ gegeben ist durch ${k}_{m} = n ⋅ {E}_{Si} ⋅ h \frac{{b}^{3}}{{l}^{3}}$ mit n der Anzahl der Federelemente, E_{Si} dem Elastizitätsmodul von Silizium, h der Höhe der Federelemente 120 senkrecht zum Substrat, b deren Breite in Schwingungsrichtung x und l deren Länge parallel zum Substrat und senkrecht zur Schwingungsrichtung x.

Die Empfindlichkeit der Resonanzfrequenz auf Änderungen der Spannung U ist dann $\frac{df \left(U\right)}{dU} = \frac{- 2 gU}{2 π \sqrt{m} ⋅ 2 ⋅ \sqrt{{k}_{m} - g ⋅ {U}^{2}}} = \frac{- gU}{2 π \sqrt{m} ⋅ \sqrt{{k}_{m} - g ⋅ {U}^{2}}} = \frac{- gU}{2 π \sqrt{m ⋅ {k}_{m} \left(1-β\right)}}$ wenn man den Kompensationsfaktor β einführt, für den gilt β·kₘ = g·U².

Eine große Empfindlichkeit kann daher z.B. durch eine relativ große Spannung U oder einen großen Faktor g erreicht werden, d.h. eine möglichst große effektive Trimmelektrodenfläche N·L·h bei möglichst kleinem Spaltabstand d. Eine große Empfindlichkeit kann überdies durch eine kleine Masse m der Probemasse 110 und eine kleine mechanische Federkonstante kₘ, erreicht werden, d.h. durch eine geringe Breite b und eine große Länge I.

Quantifiziert man die auflösbare Spannungsänderung als Bruchteil der zu messenden Spannung U mit dU = α·U, so ergibt sich als Relation zwischen der daraus resultierenden Frequenzänderung df und der Ausgangsfrequenz f $\begin{matrix}df = \frac{- gU}{2 π \sqrt{m ⋅ {k}_{m} \left(1-β\right)}} dU = \frac{- {gU}^{2}}{2 π \sqrt{m ⋅ {k}_{m} \left(1-β\right)}} ⋅ α = = \\ \frac{- β ⋅ {k}_{m}}{2 π \sqrt{m ⋅ {k}_{m} \left(1-β\right)}} ⋅ α = - \frac{β}{\sqrt{\left(1-β\right)}} ⋅ α ⋅ f\end{matrix}$

Die relative Frequenzstabilität beträgt ca. 10ppm, d.h. Anderungen der Frequenz in der Größenordnung von 10ppm der Ausgangsfrequenz sind nicht schnell als Messsignal zu identifizieren. Es sollte also gelten $\frac{df}{f} = \frac{β}{\sqrt{\left(1-β\right)}} ⋅ α > 100 ppm$

Wählt man z.B. α = 50ppm, d.h. einen bereits sehr niedrigen Wert für den Drift von Referenzspannungen innerhalb eines Jahres, so ergibt sich für den Kompensationsfaktor β $β > 0.828$

Bei bekanntem β lassen sich die verschiedenen Parameter des MEMS 100 der Fig. 4 unter der Berücksichtigung der Tatsache anpassen, dass β·kₘ = kₑₗ gelten muss, aus der sich die Vorgabe ergibt $\frac{β ⋅ {E}_{Si}}{2 ⋅ {ε}_{0}} ⋅ n ⋅ \frac{{b}^{3}}{{l}^{3}} = \frac{N ⋅ L ⋅ {U}^{2}}{{d}^{3}}$

Anhand dieser Vorgaben lässt sich das MEMS 100 im Prinzip auf beliebige zu messende Spannungen U anpassen, d.h. es ist möglich das MEMS 100 für die Messung von speziellen Referenzspannungen mit einem bekannten Wertebereich auszugestalten. Auf diese Weise lassen sich hochpräzise Spannungsmesser für sich langsam ändernde Spannungen realisieren.

Zusätzlich hilfreich ist es hierbei wenn das MEMS 100 derart ausgestaltet ist, dass das durch die Schwingungen der Probemasse 110 erzeugte Schwingungssystem bei mit der zu messenden Spannung U beaufschlagten Trimmelektroden 130 eine Güte von mehr als 1.000 aufweist. Dadurch wird die Resonanzfrequenz des Systems besonders gut messbar.

Zu diesem Zweck, aber auch um die Komponenten des MEMS 100 zu schützen, kann das MEMS 100 ein Gehäuse 160 aufweisen, das in der Fig. 4 symbolisch als gestrichelte Umfassung der MEMS-Komponenten dargestellt ist. Das Gehäuse 160 umfasst insbesondere die Probemasse 110, die Federelemente 120, die Trimmelektroden 130, die Antriebselektroden 140 und die Ausleseelektroden 150. Das Gehäuse 160 und damit die MEMS-Komponenten im Gehäuse 160 können evakuiert sein. Dadurch entfallen der Luftwiderstand und die daraus resultierende Dämpfung, wodurch sich die Güte des Systems (weiter) verbessert.

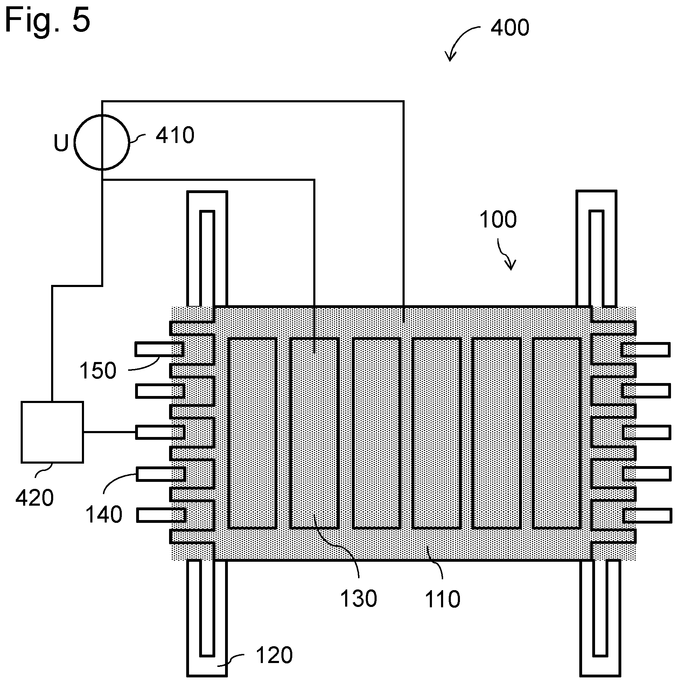

Von besonderem Interesse ist der Einsatz der oben beschriebenen Technologie in einem Beschleunigungssensor 400. Ein derartiger Beschleunigungssensor 400 ist schematisch in der Fig. 5 gezeigt.

Der Beschleunigungssensor 400 weist das MEMS 100 auf, das geeignet ist, eine Beschleunigung zu messen, die entlang der Schwingungsrichtung x der Probemasse 110 auf den Beschleunigungssensor 300 wirkt, indem die Schwingungsfrequenz der Probemasse 110 gemessen wird. Hierzu können wie in der Fig. 4 gezeigt die Trimmelektroden 130 als Ausleseelektroden 150 verwendet werden. Es kann aber auch von Vorteil sein, die Schwingungen der Probemasse 110 über separate Ausleseelektroden 150 zu erfassen. Diese können zusammen mit den Antriebselektroden 140 an den Seiten der Probemasse 110 angeordnet sein, wie in der Fig. 5 gezeigt. Die seitlichen Elektroden können aber durch zeitliches Multiplexing sowohl als Antrieb- als auch als Ausleseelektroden betrieben werden.

Auf diese Weise lässt sich jeder entsprechend der obigen Überlegungen strukturierte Beschleunigungssensor 400 auch als Vorrichtung zur Spannungsmessung verwenden, wenn ein gesonderter Anschluss der Trimmelektroden 130 an eine Spannungsquelle möglich ist. Dadurch lassen sich mit dem Beschleunigungssensor 400 weitere Funktionen realisieren, die über die bloße Beschleunigungsmessung hinausgehen.

Wie in der Fig. 5 ebenfalls dargestellt ist die zu messende Spannung U gleich einer Referenzspannung, die zur Bestimmung einer an die Antriebselektroden 140 bzw. die Ausleseelektroden 150 angelegten Betriebsspannung verwendet wird. Das heißt, der Beschleunigungssensor 400 umfasst eine Referenzspannungsquelle 410. Die von dieser Referenzspannungsquelle 410 erzeugte Referenzspannung wird sowohl an die Trimmelektroden 130 als auch an einen Spannungsgenerator 420 angelegt. Der Spannungsgenerator 420 erzeugt die Betriebsspannung für die Antriebselektroden 140 und/oder die Ausleseelektroden 150 aus der Referenzspannung, z.B. indem die Referenzspannung U skaliert und/oder moduliert wird, etwa in Form einer Sinusmodulation.

Wie oben erläutert ist der Skalenfaktor, der die gemessene Schwingung in eine Beschleunigung umsetzt, quadratisch abhängig von der Betriebsspannung und damit auch von der Referenzspannung U. Durch Anlegen der Referenzspannung U an die Trimmelektroden 130 und das Überwachen von Auswirkungen von möglichen Änderungen der Referenzspannung U auf das Schwingungssystem kann eine Drift des Skalenfaktors erkannt und korrigiert werden. Auf diese Weise können hochgenaue und langzeitstabile Beschleunigungssensoren 400 bereitgestellt werden.

Die oben beschriebene Ausgestaltung des MEMS 100 ist hierbei rein beispielhaft. Es ist eine Vielzahl von alternativen Ausgestaltungen möglich, solange das Ziel erreicht wird, durch Änderungen der Spannung an Trimmelektroden 130 eine präzise messbare Änderung der Schwingung der Probemasse 110 herbeizuführen. Das richtige Layout für derartige Sensoren kann von einem Fachmann analog zu den oben angestellten Überlegungen hergeleitet werden.

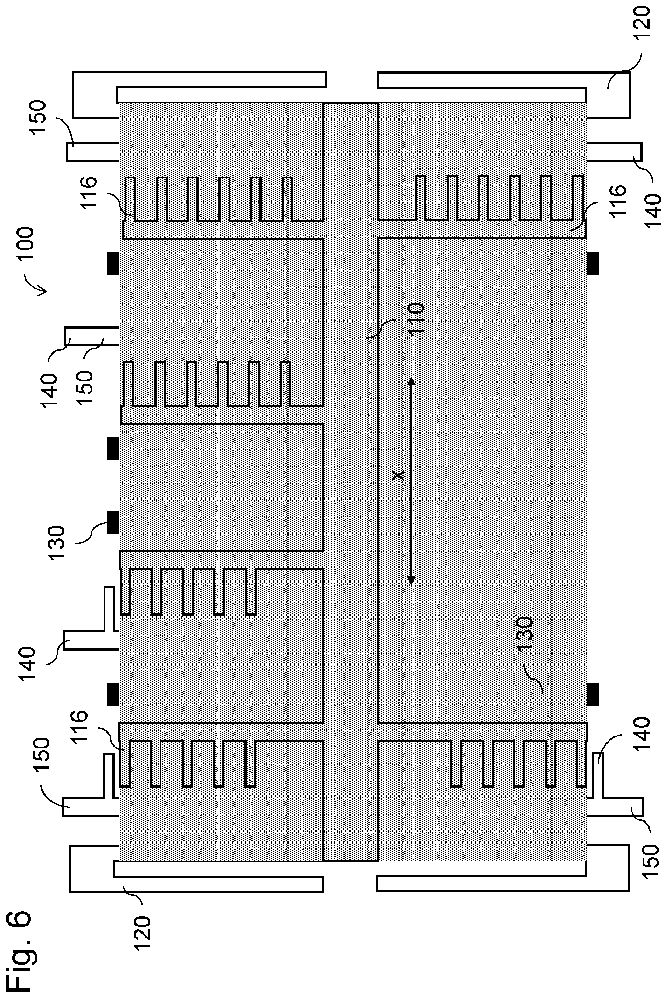

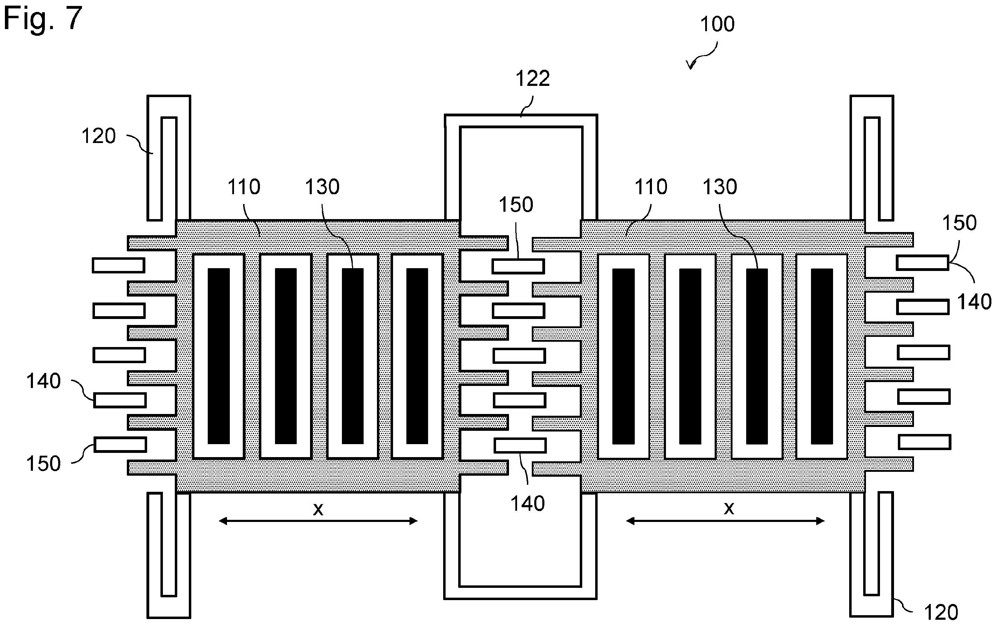

Die Fig. 6 und 7 zeigen beispielhaft solche alternativen Ausgestaltungen. Wie in der Fig. 6 dargestellt kann das MEMS 100 eine Probemasse 110 aufweisen, die als sich hauptsächlich in Auslenkungsrichtung x erstreckender Balken ausgestaltet ist. An ihren Enden ist die Probemasse 110 jeweils über zwei als gefaltete Biegebalkenfedern ausgebildete Federelemente 120 mit dem Substrat verbunden.

Ebenfalls auf dem Substrat sind eine Reihe als Kammelektroden ausgebildete Antriebselektroden 140 und Ausleseelektroden 150 angebracht, wobei der gleiche Elektrodenkamm sowohl als Antriebselektrode 140 als auch als Ausleseelektrode 150 verwendet werden kann. Die Antriebs-/Ausleseelektroden 140, 150 greifen in an der Probemasse 110 angeordnete Gegenelektroden 116 in der Form von Kammelektroden ein. Durch Anlegen einer Spannung zwischen Antriebs-/Ausleseelektroden 140, 150 und den Gegenelektroden 116 kann die Probemasse 110 in Schwingung entlang der Schwingungsrichtung x versetzt werden. Die Schwingung kann z.B. durch Detektion der Ladung auf den Elektroden bei konstanter Spannung oder durch Detektion der Spannung bei konstanter Ladung (d.h. bei unterbrochenem Stromfluss auf die Elektroden) bestimmt werden.

An der Rückseite der Gegenelektroden 116 sind Trimmelektroden 130 angebracht, die der mechanischen Federkraft entgegenwirken, wenn eine Spannung an sie angelegt wird. Wie auch bereits oben beschrieben, können auch die Trimmelektroden 130 als Ausleseelektroden 130 fungieren.

Die Fig. 7 zeigt einen schematischen Aufbau eines MEMS 100, das im Wesentlichen aus einer Dopplung der Struktur des in der Fig. 4 gezeigten MEMS 100 resultiert. Hierbei teilen sich zwei Probemassen 110 einen mittig angeordneten Satz von Antriebs-/Ausleseelektroden 140, 150. In diesem Bereich sind die beiden Probemassen 110 durch Kopplungsfedern 122 verbunden, die eine (auch gegenläufige) Schwingung beider Probemassen 110 entlang der Schwingungsrichtung x erlauben. Ansonsten entspricht der Aufbau jeder der Hälften des MEMS 100 der Fig. 7 dem des MEMS 100 der Fig. 4. Eine weitere Beschreibung erübrigt sich daher.

Auch die beiden Ausgestaltungen der Fig. 6 und 7 ermöglichen es, so wie viele weitere mögliche Ausgestaltungen, Referenzspannungen zu messen, indem die Spannungen an Trimmelektroden 130 angelegt werden und die resultierenden Auswirkungen auf das Schwingungsverhalten überwacht werden. Einem Fachmann steht also eine Vielzahl von Möglichkeiten offen, das eingangs genannte Problem im Rahmen der Patentansprüche zu lösen.

## Patentansprüche

1. Verfahren zum Messen einer Spannung mittels eines mikro-elektro-mechanischen Systems, MEMS, (100) mit einer Probemasse (110), die mittels mechanischen Federelementen (120) derart über einem Substrat gelagert wird, dass sie entlang einer Schwingungsrichtung (x) relativ zu dem Substrat bewegt werden kann, Trimmelektroden (130), die geeignet sind, bei einer Beaufschlagung mit einer Spannung eine elektrostatische Kraft auf die Probemasse (110) zu erzeugen, die bei einer Auslenkung der Probemasse (110) entlang der Schwingungsrichtung (x) einer durch die Federelemente (120) erzeugten mechanischen Federkraft entgegenwirkt, Antriebselektroden (140), die geeignet sind, die Probemasse (110) entlang der Schwingungsrichtung (x) in Bewegung zu versetzen, und Ausleseelektroden (150), die geeignet sind, eine Schwingungsfrequenz der derart erzeugten Schwingung der Probemasse (110) zu messen, wobei das Verfahren aufweist:
Anlegen einer zu messenden Spannung (U) an die Trimmelektroden (130);
Messen der Größe der zu messenden Spannung (U) aus der gemessenen Schwingungsfrequenz der Probemasse (110); und
Detektieren von Änderungen der zu messenden Spannung (U) anhand der Änderung der gemessenen Schwingungsfrequenz,
**dadurch gekennzeichnet, dass**
die zu messende Spannung (U) eine Referenzspannung ist, deren Größe die Grundlage weiterer Mess- und/oder Rechenoperationen ist; und
das Verfahren des Weiteren aufweist:
Korrigieren der weiteren Mess- und/oder Rechenoperationen durch Ersetzen der erwarteten Referenzspannung durch die gemessene Referenzspannung.

2. Verfahren nach Anspruch 1, wobei
durch das Anlegen der zu messenden Spannung (U) an die Trimmelektroden (130) zwischen 50% und 90%, vorzugsweise zwischen 60% und 80%, weiter vorzugsweise 75% der mechanischen Federkraft kompensiert werden.

3. Verfahren nach einem der vorherigen Ansprüche, wobei
das Verfahren ausgeführt wird, während das MEMS (100) sich in Ruhe befindet.

4. Mikro-elektro-mechanisches System, MEMS, (100) zum Messen einer Spannung, aufweisend:
eine Probemasse (110), die mittels mechanischen Federelementen (120) derart über einem Substrat gelagert wird, dass sie entlang einer Schwingungsrichtung (x) relativ zu dem Substrat bewegt werden kann;
Trimmelektroden (130), die geeignet sind, bei einer Beaufschlagung mit einer Spannung eine elektrostatische Kraft auf die Probemasse (110) zu erzeugen, die bei einer Auslenkung der Probemasse (110) entlang der Schwingungsrichtung (x) einer durch die Federelemente (120) erzeugten mechanischen Federkraft entgegenwirkt;
Antriebselektroden (140), die geeignet sind, die Probemasse (110) entlang der Schwingungsrichtung (x) in Bewegung zu versetzen, und Ausleseelektroden (150), die geeignet sind, eine Schwingungsfrequenz der derart erzeugten Schwingung der Probemasse (110) zu messen; und
einer Steuereinheit, die geeignet ist, das MEMS (100) derart zu steuern, dass es das Verfahren nach einem der vorherigen Ansprüche ausführt.

5. MEMS (100) nach Anspruch 4, wobei
das MEMS (100) derart ausgestaltet ist, dass sich die Resonanzfrequenz der Schwingung der Probemasse (110) bei mit der zu messenden Spannung (U) beaufschlagten Trimmelektroden (130) bei einer Spannungsänderung von 1 mV um einen Wert aus dem Bereich 100 ppm bis 1.000 ppm der Resonanzfrequenz ändert.

6. MEMS (100) nach Anspruch 5, wobei
die Änderung der Resonanzfrequenz mit der Spannungsänderung nicht linear von der Auslenkung der Probemasse (110) abhängt; und/oder
die Resonanzfrequenz sich mit der Umgebungstemperatur ändert; und
die Steuereinheit geeignet ist, diese Abhängigkeiten durch Kalibration beim Detektieren der zu messenden Spannung (U) zu berücksichtigen.

7. MEMS (100) nach einem der Ansprüche 4 bis 6, wobei
das MEMS (100) derart ausgestaltet ist, dass das durch die Schwingungen der Probemasse (110) erzeugte Schwingungssystem bei mit der zu messenden Spannung (U) beaufschlagten Trimmelektroden (130) eine Güte von mehr als 1.000 aufweist.

8. MEMS (100) nach einem der Ansprüche 4 bis 7, wobei
die Probemasse (110), die Federelemente (120), die Trimmelektroden (130), die Antriebselektroden (140) und die Ausleseelektroden (150) evakuiert sind.

9. Beschleunigungssensor (400) zum Messen von Beschleunigungen mit
dem MEMS (100) nach einem der Ansprüche 4 bis 8, wobei
das MEMS (100) geeignet ist, eine Beschleunigung zu messen, die entlang der Schwingungsrichtung (x) der Probemasse (110) auf den Beschleunigungssensor (300) wirkt, indem die Schwingungsfrequenz der Probemasse (110) gemessen wird.

10. Beschleunigungssensor (300) nach Anspruch 9, wobei
die Referenzspannung zur Bestimmung einer an die Antriebselektroden (140) und/oder Ausleseelektroden (150) angelegten Betriebsspannung dient.

## Claims

1. A method for measuring a voltage by means of a micro-electro-mechanical system, MEMS, (100) comprising a sample mass (110) which is mounted above a substrate by means of mechanical spring elements (120) in such a way that it can be moved relative to the substrate along a direction of vibration (x), trim electrodes (130) which are suitable for generating an electrostatic force on the sample mass (110) when a voltage is applied to them, the electrostatic force counteracting a mechanical spring force generated by the spring elements (120) when the sample mass (110) is deflected along the direction of vibration (x), drive electrodes (140) which are suitable for setting the sample mass (110) in motion along the direction of vibration (x), and readout electrodes (150) which are suitable for measuring a vibration frequency of the vibration of the sample mass (110) generated in such a way, wherein the method includes:
applying a voltage (U) to be measured to the trim electrodes (130);
measuring the magnitude of the voltage (U) to be measured from the measured vibration frequency of the sample mass (110); and
detecting changes in the voltage (U) to be measured on the basis of the change in the measured vibration frequency,
**characterized in that**
the voltage (U) to be measured is a reference voltage, the magnitude of which is the basis for further measurement and/or calculation operations; and
the method further includes:
correcting the further measurement and/or calculation operations by replacing the anticipated reference voltage with the measured reference voltage.

2. The method according to claim 1, wherein,
by applying the voltage (U) to be measured to the trim electrodes (130), between 50% and 90%, preferably between 60% and 80%, more preferably 75% of the mechanical spring force are compensated for.

3. The method according to any one of the preceding claims, wherein
the procedure is carried out while the MEMS (100) is at rest.

4. A micro-electro-mechanical system, MEMS, (100) for measuring a voltage, including:
a sample mass (110) which is mounted above a substrate by means of mechanical spring elements (120) in such a way that it can be moved relative to the substrate along a direction of vibration (x);
trim electrodes (130) which are suitable for generating an electrostatic force on the sample mass (110) when a voltage is applied to them, the electrostatic force counteracting a mechanical spring force generated by the spring elements (120) when the sample mass (110) is deflected along the direction of vibration (x);
drive electrodes (140) which are suitable for setting the sample mass (110) in motion along the direction of vibration (x), and readout electrodes (150) which are suitable for measuring a vibration frequency of the vibration of the sample mass (110) generated in such a way; and
a control unit which is suitable for controlling the MEMS (100) in such a way that it carries out the method according to any one of the preceding claims.

5. The MEMS (100) according to claim 4, wherein
the MEMS (100) is designed in such a way that the resonant frequency of the vibration of the sample mass (110) changes by a value from the range of 100ppm to 1,000ppm of the resonant frequency when the voltage (U) to be measured is applied to the trim electrodes (130) in case of a change in voltage of 1mV.

6. The MEMS (100) according to claim 5, wherein
the change in the resonant frequency with the change in voltage does not depend linearly on the deflection of the sample mass (110); and/or
the resonant frequency changes with the ambient temperature; and
the control unit is suitable for taking into account these dependencies through calibration when detecting the voltage (U) to be measured.

7. The MEMS (100) according to any one of claims 4 to 6, wherein
the MEMS (100) is designed in such a way that the vibration system generated by the vibrations of the sample mass (110) has a performance of more than 1,000 when the voltage (U) to be measured is applied to the trim electrodes (130).

8. The MEMS (100) according to any one of claims 4 to 7, wherein
the sample mass (110), the spring elements (120), the trim electrodes (130), the drive electrodes (140), and the readout electrodes (150) are evacuated.

9. An acceleration sensor (400) for measuring acceleration, comprising:
the MEMS (100) according to any one of claims 4 to 8, wherein
the MEMS (100) is suitable for measuring an acceleration that acts on the acceleration sensor (300) along the direction of vibration (x) of the sample mass (110) by measuring the vibration frequency of the sample mass (110).

10. The acceleration sensor (300) according to claim 9, wherein
the reference voltage is used for determining an operating voltage applied to the drive electrodes (140) and/or readout electrodes (150).

## Revendications

1. Procédé pour mesurer une tension au moyen d'un système micro-électromécanique, MEMS, (100) comprenant une masse d'échantillon (110) qui est supportée au-dessus d'un substrat au moyen d'éléments à ressort mécaniques (120) de telle sorte qu'elle puisse être déplacée par rapport au substrat le long d'une direction de vibration (x), des électrodes de compensation (130), qui sont adaptées pour, lorsqu'elles sont sollicitées par une tension, générer sur la masse d'échantillon (110) une force électrostatique qui va à l'encontre d'une force de ressort mécanique générée par les éléments à ressort (120) lorsque la masse d'échantillon (110) est déviée le long de la direction de vibration (x), des électrodes d'entraînement (140), qui sont adaptées pour mettre la masse d'échantillon (110) en mouvement le long de la direction de vibration (x), et des électrodes de lecture (150) qui sont adaptées pour mesurer une fréquence de vibration de l'oscillation de la masse d'échantillon (110) générée de cette manière, dans lequel le procédé présente les étapes :
appliquer une tension (U) à mesurer aux électrodes de compensation (130) ;
mesurer la grandeur de la tension (U) à mesurer à partir de la fréquence de vibration mesurée de la masse d'échantillon (110) ; et
détecter des variations de la tension (U) à mesurer à partir de la variation de la fréquence de vibration mesurée,
**caractérisé en ce que**
la tension (U) à mesurer est une tension de référence, dont la grandeur est la base d'autres opérations de mesure et/ou de calcul ; et
le procédé présente en outre les étapes :
corriger les autres opérations de mesure et/ou de calcul en remplaçant la tension de référence attendue par la tension de référence mesurée.

2. Procédé selon la revendication 1, dans lequel
par l'application de la tension (U) à mesurer aux électrodes de compensation (130), on compense entre 50 % et 90 % de la force de ressort mécanique, de préférence entre 60 % et 80 %, de manière davantage préférentielle 75 %.

3. Procédé selon l'une des revendications précédentes, dans lequel
le procédé est mis en œuvre alors que le MEMS (100) est au repos.

4. Système micro-électromécanique, MEMS, (100) de mesure d'une tension, présentant :
une masse d'échantillon (110) qui est supportée au-dessus d'un substrat au moyen d'éléments à ressort mécaniques (120) de telle sorte qu'elle puisse être déplacée par rapport au substrat le long d'une direction de vibration (x) ;
des électrodes de compensation (130), qui sont adaptées pour, lorsqu'elles sont sollicitées par une tension, générer sur la masse d'échantillon (110) une force électrostatique qui va à l'encontre d'une force de ressort mécanique générée par les éléments à ressort (120) lorsque la masse d'échantillon (110) est déviée le long de la direction de vibration (x) ;
des électrodes d'entraînement (140), qui sont adaptées pour mettre la masse d'échantillon (110) en mouvement le long de la direction de vibration (x), et des électrodes de lecture (150), qui sont adaptées pour mesurer une fréquence de vibration de l'oscillation de la masse d'échantillon (110) générée de cette manière ; et
une unité de commande qui est adaptée pour commander le MEMS (100) de telle sorte qu'il mette en œuvre le procédé selon l'une des revendications précédentes.

5. MEMS (100) selon la revendication 4, dans lequel
le MEMS (100) est configuré de telle sorte que la fréquence de résonance de l'oscillation de la masse d'échantillon (110) varie d'une valeur dans la plage de 100 ppm à 1000 ppm de la fréquence de résonance lorsque les électrodes de compensation (130) sont sollicitées par la tension (U) à mesurer lors d'une variation de tension de 1 mV.

6. MEMS (100) selon la revendication 5, dans lequel
la variation de la fréquence de résonance avec la variation de tension dépend de manière non linéaire de la déviation de la masse d'échantillon (110) ; et/ou
la fréquence de résonance varie avec la température ambiante ; et
l'unité de commande est adaptée pour tenir compte de ces dépendances par calibrage lors de la détection de la tension (U) à mesurer.

7. MEMS (100) selon l'une des revendications 4 à 6, dans lequel
le MEMS (100) est configuré de telle sorte que le système de vibration généré par les oscillations de la masse d'échantillon (110) présente une qualité supérieure à 1000 avec des électrodes de compensation (130) sollicitées par la tension (U) à mesurer.

8. MEMS (100) selon l'une des revendications 4 à 7, dans lequel
on fait le vide dans la masse d'échantillon (110), les éléments à ressort (120), les électrodes de compensation (130), les électrodes d'entraînement (140) et les électrodes de lecture (150).

9. Capteur d'accélération (400) pour mesurer les accélérations comprenant
le MEMS (100) selon l'une des revendications 4 à 8, dans lequel
le MEMS (100) est adapté pour mesurer une accélération qui agit sur le capteur d'accélération (300) le long de la direction de vibration (x) de la masse d'échantillon (110) en mesurant la fréquence de vibration de la masse d'échantillon (110).

10. Capteur d'accélération (300) selon la revendication 9, dans lequel
la tension de référence sert à déterminer une tension de fonctionnement appliquée aux électrodes d'entraînement (140) et/ou aux électrodes de lecture (150).
